# EUROPEAN PATENT APPLICATION

(11) **EP 4 737 388 A1**
(43) Date of publication of application: **06.05.2026**
(21) Application number: 24209459.7
(22) Date of filing: 29.10.2024
(51) Int. Cl.: B81B 7/00, B81C 1/00, H04R 1/08

(54) **TWO-STEP LASER PROCESSING FOR PRODUCING A MEMS CHIP COMPRISING AN ENVIRONMENTAL BARRIER STRUCTURE MADE FROM POLYMER NANOFIBERS**

(71) Applicant: Infineon Technologies AG, 85579 Neubiberg (DE)
(72) Inventor: ANZINGER, Sebastian, 83714 Miesbach (DE); WASISTO, Hutomo Suryo, 81541 München (DE); MAIER, Dominic, 92714 Pleystein (DE); SOTNIKOV, Anatoly, 93055 Regensburg (DE); FÜLDNER, Marc, 85579 Neubiberg (DE)
(74) Representative: Fischer, Florian

(57) **Abstract**

A method for producing a MEMS chip (100) with an environmental barrier structure (150) made from polymer nanofibers (151), the method comprising providing a wafer substrate (110) having plurality of adjacent through holes (131, ..., 134). The environmental barrier structure (150) is created by applying polymer nanofibers (151) onto one of the front and back sides (111, 112) of the wafer substrate (110). A plurality of MEMS chips (100) are singulated from the wafer substrate (110) by applying a two-step laser process comprising: a first laser-processing step including guiding a laser beam (160) over the one side of the wafer substrate (110) at which the polymer nanofibers (151) are applied in order to locally remove the polymer nanofibers (151) from the wafer substrate (110) and to locally uncover an underlying surface, and a subsequent second laser-processing step including applying a stealth dicing process for singulating the MEMS chips (100) by guiding a stealth dicing laser beam over the locally uncovered surfaces.

## Description

Embodiments of the present disclosure relate to a method for producing a MEMS chip (MEMS: Micro Electro Mechanical System) with an environmental barrier structure made from polymer nanofibers.

### TECHNICAL BACKGROUND

Next generation MEMS chips, for example MEMS microphones and other sensors, are expected to have environmental barriers (EBs) in their package construction to be able to withstand harsh environmental conditions, including impacting solid objects (e.g., dust particles and hairs) and high water ingression.

Currently available solutions from MEMS chip manufacturers rely on external and large environmental barriers (EBs) that are placed far away from the MEMS chip itself, leading to high production cost, large package size, low performance, and limited usage for applications.

In addition, currently used materials are often based on per- and polyfluoroalkyl substances (PFAS). However, the European Chemicals Agency (ECHA) published a comprehensive dossier concerning a ban on around 10,000 PFAS, which are widely used in many industries and present in many consumer goods. The restriction proposal aims to restrict the manufacture, placing on the market and use of substances harmful to human health and the environment, and to limit their associated risks.

To overcome the above restrictions, the applicant of the present disclosure presented an innovative approach of creating an environmental barrier structure by spinning polymer nanofibers onto MEMS chips, either on wafer level or on chip level. These innovative EB structures are described in EP 4 380 182 A1, EP 4 380 183 A1 and EP4 378 882 A1, the contents of which are incorporated herein by reference in their entirety.

Creating the EB structures on wafer level is sometimes preferred over chip level production due to a higher yield in less time. However, during ongoing research it was discovered that singulating the single MEMS chips from the wafer by applying standard dicing processes, such as stealth dicing, may sometimes result in uneven dicing lines and incomplete separation of the nanofibrous EB structure. In some instances, the nanofibrous EB structures were peeled off from the underlying substrate, in particular in case of polysilicon substrate material, since there may be poor adhesion forces between polymer nanofibers and poly-silicon.

Therefore, it would be desirable to provide a concept for reliably and repeatedly performing dicing for singulating MEMS chips with nanofibrous EB structures from a wafer, while at the same time improving adhesion of the nanofibrous EB structures with the underlying substrate material.

This goal can be achieved by means of the herein disclosed method for producing a MEMS chip comprising an environmental barrier structure made from polymer nanofibers with all the features of the independent claim. Further embodiments and advantageous aspects are suggested in the dependent claims.

The innovative method comprises a step of providing a wafer substrate having a front side and a back side, and a step of forming a plurality of adjacent through holes in said wafer substrate. The method further comprises a step of creating the environmental barrier structure by applying polymer nanofibers onto one of the front and back sides of the wafer substrate, such that the polymer nanofibers are densely connected to form a connected web that covers the wafer substrate including the through holes. According to the herein disclosed innovative approach, the plurality of MEMS chips are singulated from the wafer substrate by applying a two-step laser process. A first laser-processing step includes a step of guiding a laser beam over the one side of the wafer at which the polymer nanofibers are applied in order to locally remove the polymer nanofibers from the wafer substrate and to uncover an underlying surface. A subsequent second laser-processing step includes a step of applying a stealth dicing process for singulating the MEMS chips by guiding a stealth dicing laser beam over the locally uncovered surfaces.

In the following, embodiments of the present disclosure are described in more detail with reference to the figures, in which
- Figs. 1A-8B: show different method steps of a first embodiment of the herein disclosed innovative method for producing a MEMS chip,
- Figs. 9A-11C: show optional further method steps of the first embodiment including melting the polymer nanofibers for creating a bonding interface between the molten polymer nanofibers and the underlying surface,
- Figs. 12A-15B: show different method steps of a second embodiment of the herein disclosed innovative method for producing a MEMS chip, and
- Figs. 16A-17B: show optional further method steps of the second embodiment including melting the polymer nanofibers for creating a bonding interface between the molten polymer nanofibers and the underlying surface.

### DESCRIPTION OF THE FIGURES

Equal or equivalent elements or elements with equal or equivalent functionality are denoted in the following description by equal or equivalent reference numerals.

Method steps which are depicted by means of a block diagram and which are described with reference to said block diagram may also be executed in an order different from the depicted and/or described order. Furthermore, method steps concerning a particular feature of a device may be replaceable with said feature of said device, and the other way around.

Accordingly, the innovative method will be structurally described in the following with reference to method steps being presented by structural features, such as substrates, EB structures, and the like.

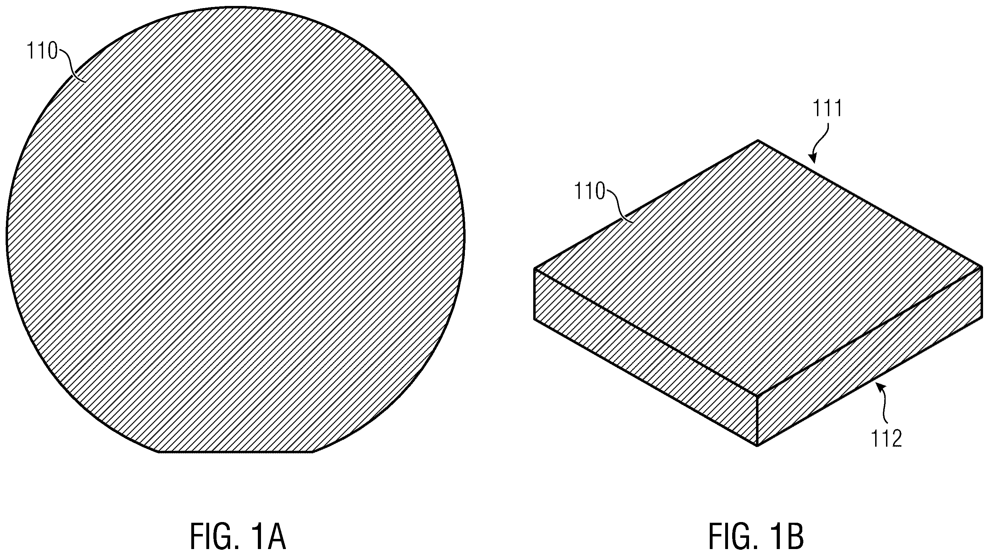

Figures 1A to 8B show a first embodiment of the herein disclosed innovative method for producing a MEMS chip comprising an environmental barrier structure made from spun polymer nanofibers.

Figure 1A shows a top view onto a wafer substrate 110. Figure 1B shows a perspective view onto the same wafer substrate 110. The wafer substrate 110 may comprise or consist of a semiconductor material, e.g., silicon or the like. Other materials, such as glass, polymers, etc. are also possible. The wafer substrate 110 has a front side 111 and an opposite back side 112.

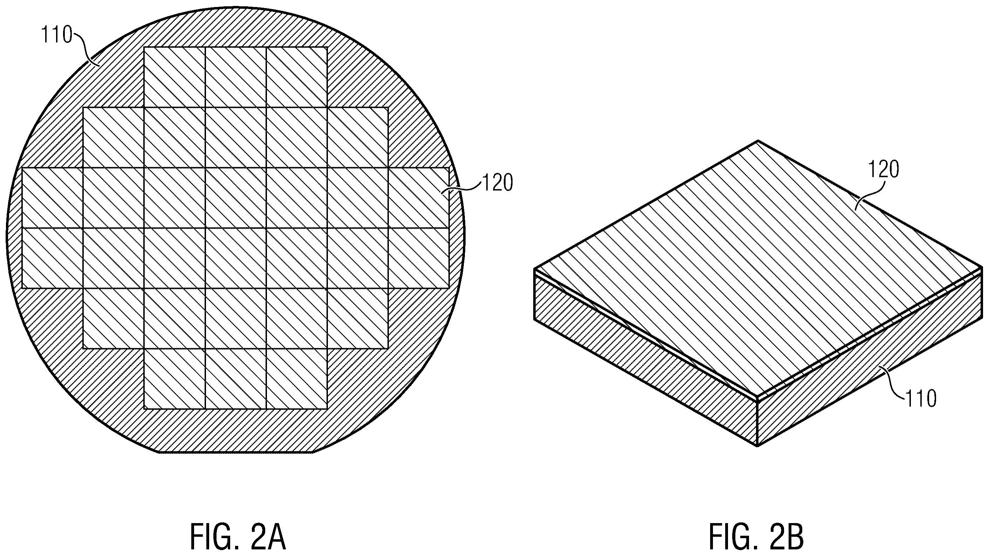

Figures 2A and 2B show a further method step, which is optional. A passivation layer 120, e.g., silicon oxide (SiO₂), may be deposited at one of the front or back sides 111, 112 of the wafer substrate 110. The passivation layer 120 may comprise or consist of tetraethyl orthosilicate, formally named tetraethoxysilane (TEOS). As shown, the passivation layer 120 may be patterned, e.g., square-patterned, which indicates the demarcations of the to-be-formed single MEMS chips.

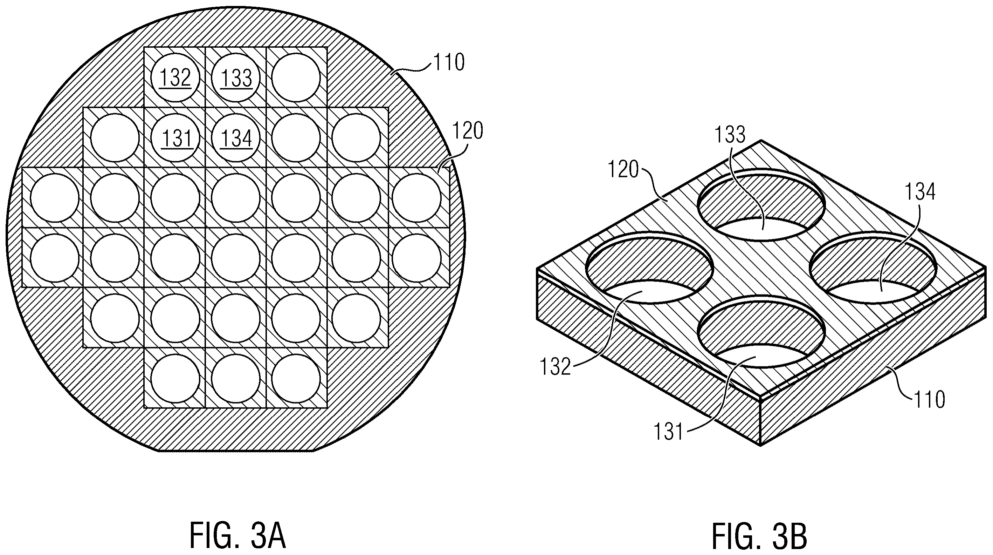

Figures 3A and 3B show a further method step, in which a plurality of adjacent through holes 131, ..., 134 are structured into the wafer substrate 110, for example by means of microstructuring techniques, such as etching. For example, the through holes 131, ..., 134 may be formed by Deep Reactive Ion Etching (DRIE). The through holes 131, ..., 134 may fully extend between the front and back side 111, 112 of the wafer substrate 110. In case an optional passivation layer 120 is present, as discussed above, the through holes 131, ..., 134 may also fully extend through said passivation layer 120.

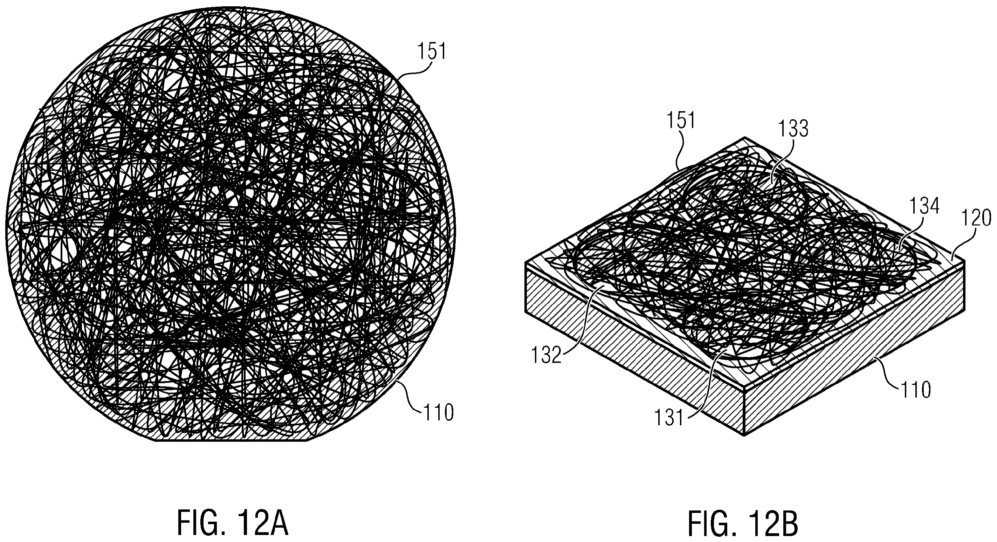

If these non-obstructed or open through holes 131, ..., 134 are provided in the wafer substrate 110, the innovative method may proceed with method steps that will be subsequently discussed with reference to Figures 12A to 17B. However, in some instances it may be advantageous to first cover the open through holes 131, ..., 134 with a rigid protective mesh for providing ingress protection from environmental substances before applying nanofibers as will be discussed later on. Furthermore, such rigid protective meshes may provide a supporting structure for the applied nanofibers.

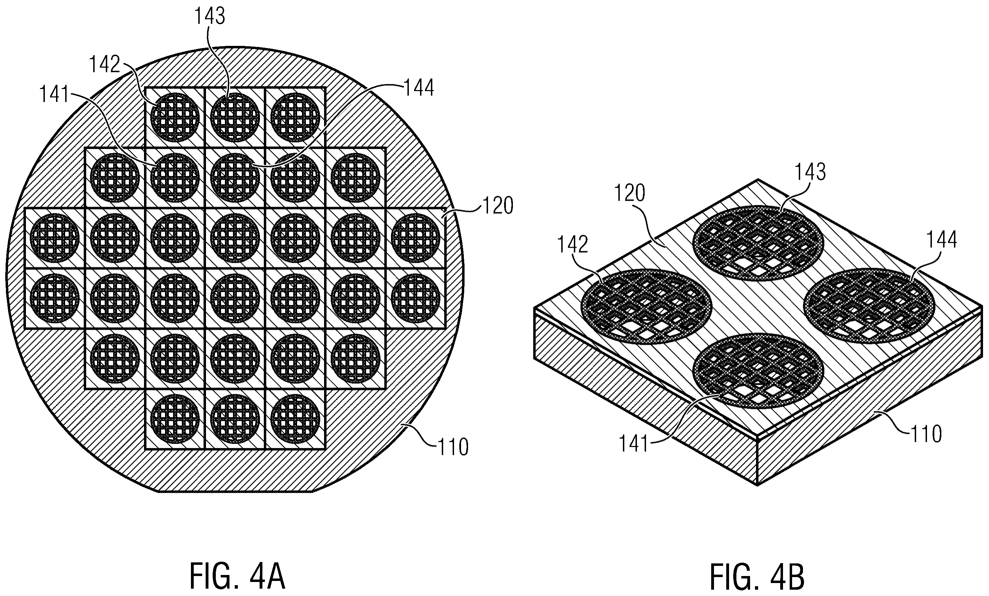

Figures 4A and 4B show corresponding exemplary method steps, in which one or more of the aforementioned through holes 131, ..., 134 may be covered with a rigid protective mesh 141, ..., 144 for providing ingress protection from environmental substances. The rigid protective meshes 141, ..., 144 may comprise or consist of semiconductor material, such as silicon, in particular polysilicon, or the like.

The rigid meshes 141, ..., 144 may reside inside the respective through holes 131, ..., 134. Alternatively, it may also be possible that the rigid meshes 141, ..., 144 may sit on top of the respective through holes 131, ..., 134. In any case, the rigid meshes 141, ..., 144 may be flush with one of the front and back sides 111, 112 of the wafer substrate 110. For example, the rigid meshes 141, ..., 144 may be flush with the front side 111 of the wafer substrate 110. In case an optional passivation layer 120 is present, the rigid meshes 141, ..., 144 may be flush with said passivation layer 120.

Regarding the formation of the rigid protective meshes 141, ..., 144, reference is made to applicant's earlier disclosures EP 4 380 182 A1, EP 4 380 183 A1 and EP4 378 882 A1, the contents of which are incorporated herein by reference in their entirety.

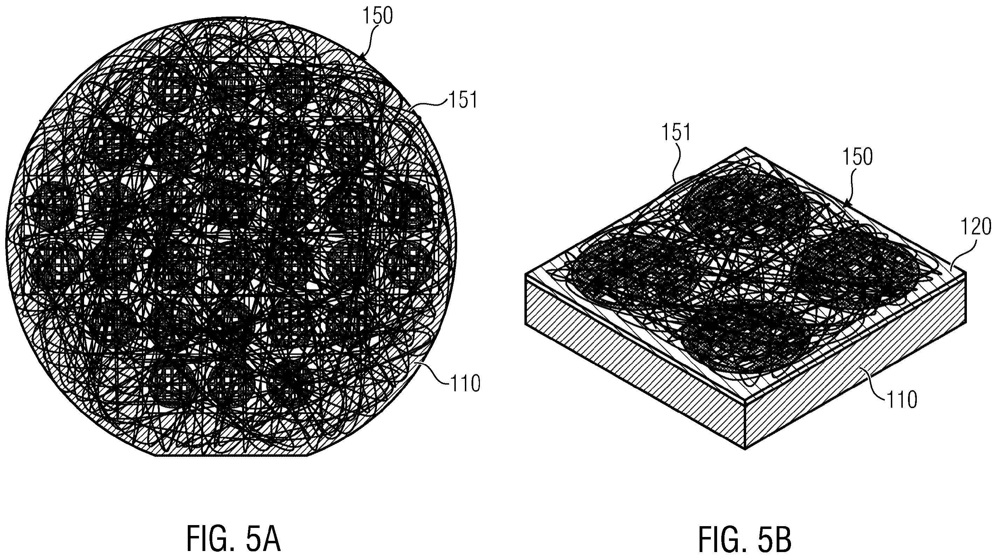

Figures 5A and 5B show a further method step, in which an environmental barrier structure 150 is created by applying polymer nanofibers 151 onto one of the front and back sides 111, 112 of the wafer substrate 110. In case an additional passivation layer 120 is present, the polymer nanofibers 151 may be applied onto said additional passivation layer 120.

In case the above described optional rigid protective meshes 141, ..., 144 are present, the polymer nanofibers 151 may also be applied onto said rigid protective meshes 141, ..., 144. In this case, it is advantageous if the rigid protective meshes 141, ..., 144 are flush with the respective surface at which the polymer nanofibers 151 are applied.

The polymer nanofibers 151 may comprise or consist of single material polymer nanofibers or of polymer composite nanofibers containing two or more different materials.

The polymer nanofibers 151 may be applied to the wafer substrate 110 by spinning, e.g., by means of electrospinning. The polymer nanofibers 151 may be applied such that the polymer nanofibers 151 are densely connected to form a connected web that covers the wafer substrate 110 including the through holes 131, ..., 134 formed therein. Said densely connected web of polymer nanofibers 151 creates an environmental barrier structure 150. Since the environmental barrier structure 150 is made from polymer nanofibers 151, it may also be referred to as a nanofibrous environmental barrier structure 150. Regarding the appliance of the polymer nanofibers 151, reference is again made to applicant's earlier disclosures EP 4 380 182 A1, EP 4 380 183 A1 and EP4 378 882 A1.

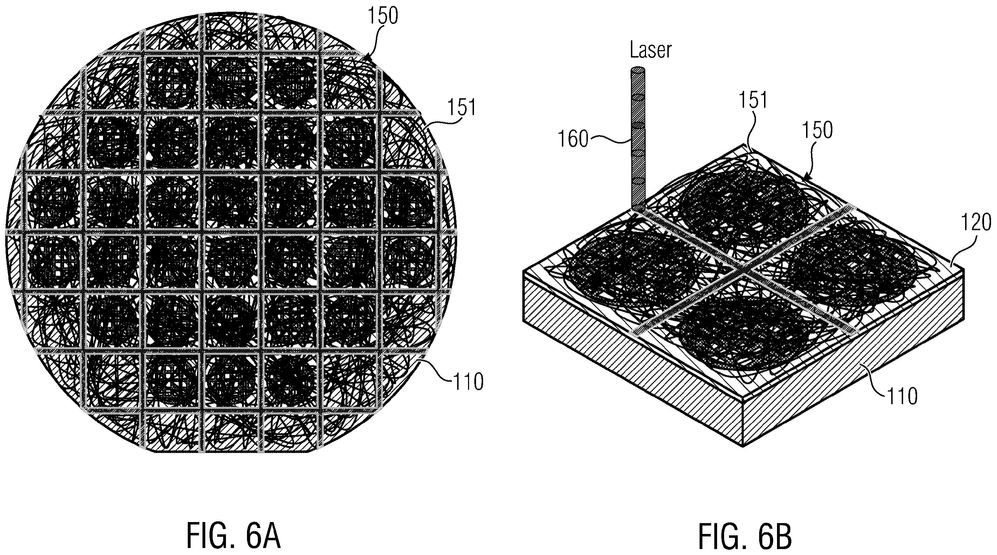

Figures 6A to 8B show further method steps of singulating a plurality of MEMS chips 100 with integrated environmental barrier structures 150 from the wafer substrate 110 by applying a two-step thermal ablation process, e.g., a two-step laser process, according to the herein disclosed innovative concept.

Figures 6A and 6B show a first thermal ablation step, e.g., a first laser-processing step, including guiding a laser beam 160 over that one side 111 of the wafer substrate 110 at which the polymer nanofibers 151 are applied in order to locally remove the polymer nanofibers 151 from the wafer substrate 110 and to uncover the underlying surface. The term locally in this regard means that the polymer nanofibers 151 are removed in the area being disposed to the laser beam 160.

In this non-limiting example, the laser beam 160 may be guided over the front side 111 of the wafer substrate 110. In case an additional passivation layer 120 is present, the laser beam 160 may be guided over said passivation layer 120. Accordingly, after the local removal of the polymer nanofibers 151 either the underlying surface of the passivation layer 120 is locally uncovered or the underlying surface of the bare substrate wafer 110 is locally uncovered.

The first laser-processing step may include applying a so-called laser grooving process for locally removing the polymer nanofibers 151.

The laser being used in the first laser-processing step may be configured / adjusted to locally remove the polymer nanofibers 151 only, i.e., without affecting / grooving the underlying surface. This can be achieved, for instance, by focusing the laser beam 160 onto the polymer nanofibers 151.

Alternatively, the laser being used in the first laser-processing step may be configured / adjusted to locally remove the polymer nanofibers 151 and groove the uncovered underlying surface. The latter example may be advantageous since a dicing line may already be pre-patterned into the locally uncovered underlying surface.

A suitable laser that may be used in the first laser-processing step can be a short-pulsed Nd:YAG laser having a wavelength between 300 nm and 400 nm.

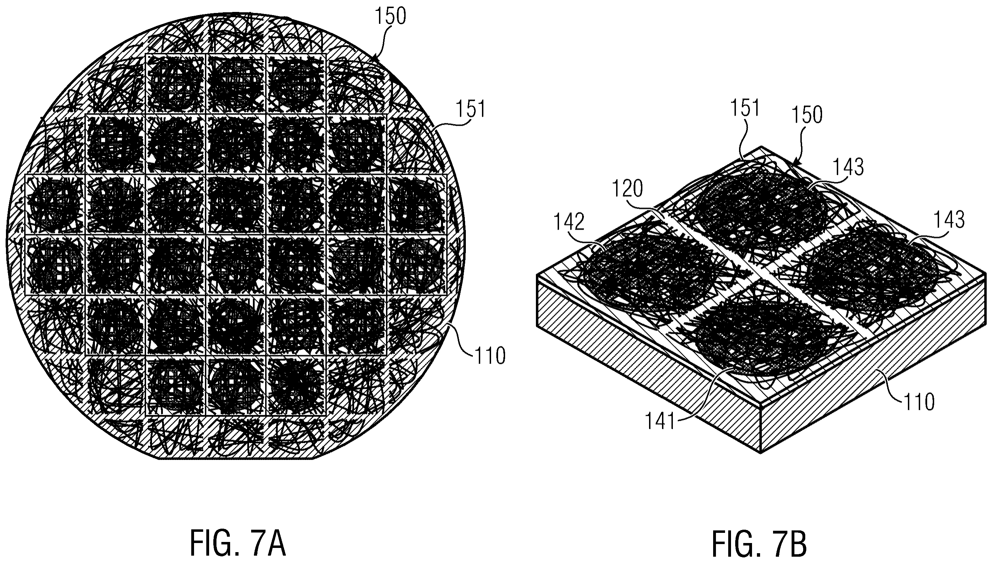

Figures 7A and 7B show the result after performing the above described first laser-processing step, i.e., Figures 7A and 7B show the condition of the separated polymer nanofibers 151 after the previously performed laser ablation (first laser-processing step). As can be seen, the polymer nanofibers 151 are locally removed in those areas that had been previously subjected to the laser beam 160. Accordingly, the underlying surface, e.g., the optional passivation layer 120, is locally uncovered in these areas.

As can further be seen in Figures 6A to 7B, the first laser-processing step may include a step of square-patterning the connected web formed by the polymer nanofibers 151 by guiding the laser beam 160 along straight lines between the previously described adjacent through holes 131, ..., 134, the straight lines being offset by 90° to each other resulting in a square pattern. Said square pattern may correspond to a desired die mapping, i.e., the polymer nanofibers 151 may be locally removed along lines, along which the final dies, i.e., the MEMS chips 100, will later be singulated.

The innovative concept further comprises a subsequent second thermal ablation step, e.g., a subsequent second laser-processing step, in which a standard chip singulation concept, such as stealth dicing, can be applied for singulating the MEMS chips 100. For example, a stealth dicing laser beam may be guided over the underlying surfaces that had previously been locally uncovered in the first laser-processing step.

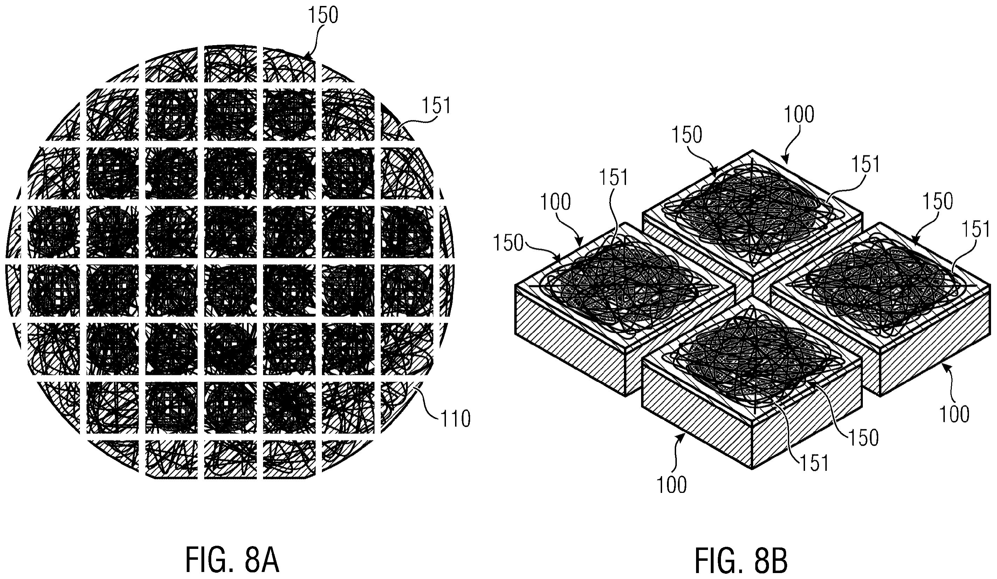

Figures 8A and 8B show the result after applying the innovative two-step laser process. As can be seen, a plurality of MEMS chips 100, each comprising an environmental barrier structure 150 made from polymer nanofibers 151, are singulated from the wafer substrate 110.

A standard stealth dicing process may be applied, in which the focus of the laser beam is set into the inside of the wafer substrate 110 for creating micro cracks therein. For example, the stealth dicing laser being used in the second laser-processing step may be a pulsed Nd:YAG laser having a wavelength between 1000 nm and 1100 nm. Accordingly, two different lasers may be used for the first and second laser-processing steps.

Even though the stealth dicing laser for the second laser-processing step may be more powerful, ongoing research of the applicant has shown that the laser beam of the stealth dicing laser may not be able to completely separate the polymer nanofibers 151 since its focus (where the most power sits) is set into the inside of the wafer substrate 110. Therefore, the stealth dicing laser beam may have less power at the site of the polymer nanofibers 151, which may result in an incomplete separation of the nanofibers 151. Accordingly, unseparated nanofiber-residues may remain at the wafer substrate 110 rendering it difficult to singulate the MEMS chips 100.

However, according to the herein described innovative concept, the polymer nanofibers 151 have been locally removed during the first laser-processing step, i.e., prior to applying the stealth dicing process. Thus, the stealth dicing laser does not need to additionally separate the polymer nanofibers 151, which would otherwise reside on the wafer surface if not removed before.

Regarding the singulated MEMS chips 100 as exemplarily depicted in Figure 8B, the applicant discovered that the environmental barrier structure 150 made from polymer nanofibers 151 may peel off from the underlying surface in some instances. For example, if a static pressure is applied from the back side 112, which may actually happen in microphone MEMS chips or pressure MEMS chips, the environmental barrier structure 150 may begin to detach from its underlying surface due to poor adhesion force.

During the herein disclosed innovative method the applicant found out that, by applying the thermal ablation process, the nanofibers 151 can be melted, wherein the molten nanofibers 151 create a bonding interface to its underlying surface. Thus, adhesion between the environmental barrier structure 150 and its underlying surface can be drastically enhanced.

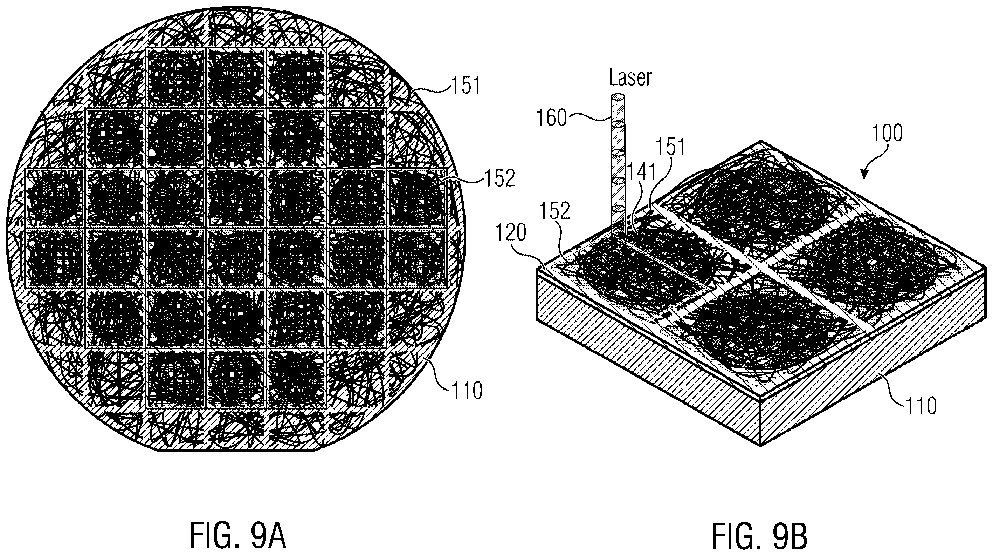

Figures 9A and 9B show an embodiment for melting the nanofibers 151. This process step is optional and can be applied, for example, after the above described first laser-processing step. As can be seen, this optional method step may contain a step of applying a thermal laser treatment including guiding a laser beam 160 over the polymer nanofibers 151 for melting them. The same laser like in the first laser-processing step may be used. Also, the laser parameters may be the same. However, it is also possible to use a different laser and/or different laser parameters.

Figure 9B shows polymer nanofibers 151 that have not yet been subjected to the thermal laser treatment and which, therefore, have not yet been melted. However, Figure 9B also shows polymer nanofibers 151 that have already been subjected to the thermal laser treatment and which, therefore, have already been melted. After curing of the molten polymer nanofibers 151, a joint interface 152 enhancing an adhesive force is created between the molten polymer nanofibers 151 and the underlying material.

Said underlying material can be at least one of the bare wafer substrate 110, the optional passivation layer 120, and the optional rigid protective mesh 141. Accordingly, the underlying material may comprise or consist of, for instance, silicon, polysilicon, TEOS or the like. It was observed that the adhesion force between the environmental barrier structure 150 and its underlying surface was enhanced for all structural parts 110, 120, 140 of the innovative MEMS chip 100 by melting the nanofibers 151, as described above. In other words, the adhesion force could be enhanced for each of the bare wafer substrate 110, the optional passivation layer 120, and the optional rigid protective mesh 141.

In the non-limiting example shown in Figures 9A and 9B, the laser beam 160 was guided over the entire chip surface, i.e., over the through holes 131, ..., 134 (Figure 3B) including the optional rigid protective meshes 141, ..., 144 and over the material surface surrounding the through holes. Accordingly, all (e.g., more than 90%) of the applied polymer nanofibers 151 may have been melted.

However, even though not explicitly shown here, it may also be possible that the polymer nanofibers 151 may only be locally melted. For example, only polymer nanofibers 151 residing adjacent to the through holes 131, ..., 134 (Figure 3B) optionally including the rigid protective meshes 141, ..., 144 may be melted. In turn, the polymer nanofibers 151 residing directly over the through holes 131, ..., 134 (Figure 3B) optionally including the rigid protective meshes 141, ..., 144 may remain unmelted.

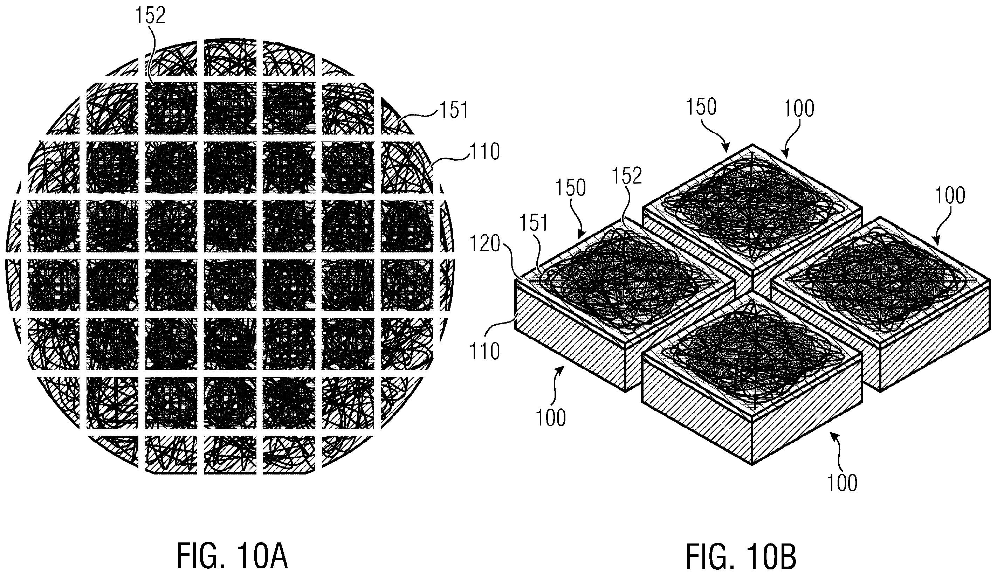

Figures 10A and 10B show the result after applying the above described second laser-processing step. A plurality of single MEMS chips 100 are created in the same or similar way as previously discussed with reference to Figures 8A and 8B, with the difference that the environmental barrier structure 150 comprises molten nanofibers 151 which create the above described bonding interface 152.

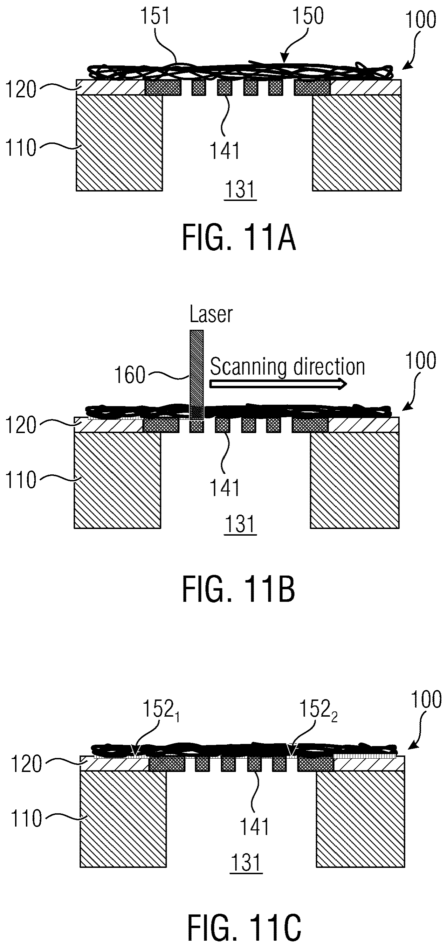

For better illustration, Figures 11A to 11C show side elevational views of an exemplary singulated MEMS chip 100 having a through hole 131 extending through the bare wafer substrate 110 and the optional passivation layer 120. Furthermore, the MEMS chip 100 comprises an optional rigid protective mesh 141.

Figure 11A shows the polymer nanofibers 151 being applied onto the MEMS chip 151.

Figure 11B shows a method step in which a laser beam 160 is guided over the surface of the MEMS chip 100 along a scanning direction. Polymer nanofibers 151 being located behind the laser beam 160 are melted.

Figure 11C shows the final result after applying the thermal laser treatment. As can be seen, the laser-treated polymer nanofibers 151 are melted, wherein the molten polymer nanofibers 151 create a bonding interface 152. For instance, the molten polymer nanofibers 151 may create a first bonding interface 152₁ with the optional passivation layer 120 and/or a second bonding interface 152₂ with the optional rigid protective mesh 141. Even though not explicitly shown here, the molten polymer nanofibers 151 may create a further bonding interface 152 with the bare wafer substrate 110.

It may also be possible that the above discussed optional method step of melting the polymer nanofibers 151 may be performed prior to, between or after any of the method steps discussed with reference to Figures 1A to 8B.

Figures 12A to 17B show a second embodiment of the herein disclosed innovative method for producing a MEMS chip 100 comprising an environmental barrier structure 150 made from spun polymer nanofibers 151. The method steps as previously discussed with reference to Figures 1A to 3B may be the same. Thus, for avoiding unnecessary repetition, it is referred to the above discussion. In particular, the method steps that will be described in the following may start after the step shown in Figures 3A and 3B, respectively.

Figures 12A and 12B show a subsequent method step starting after the one described with reference to Figures 3A and 3B above. As can be seen, the through holes 131, ..., 134 remain open unobstructed, i.e., the optional rigid protective mesh is not provided here.

Instead, the polymer nanofibers 151 are directly applied onto the wafer substrate 110, e.g., by electrospinning. In case the optional passivation layer 120 is present, the polymer nanofibers 151 are directly applied onto said passivation layer 120, as exemplarily depicted. In particular, the polymer nanofibers 151 are also applied over the non-obstructed open through holes 131, ..., 134, thereby forming a free-standing nanofiber membrane. Said free-standing nanofiber membrane may form the environmental barrier structure 150. The term free-standing, as used herein, means that the applied nanofibers 151 are not supported by an underlying rigid protective mesh 141, ..., 144, as it was explained with reference to Figures 4A to 11C.

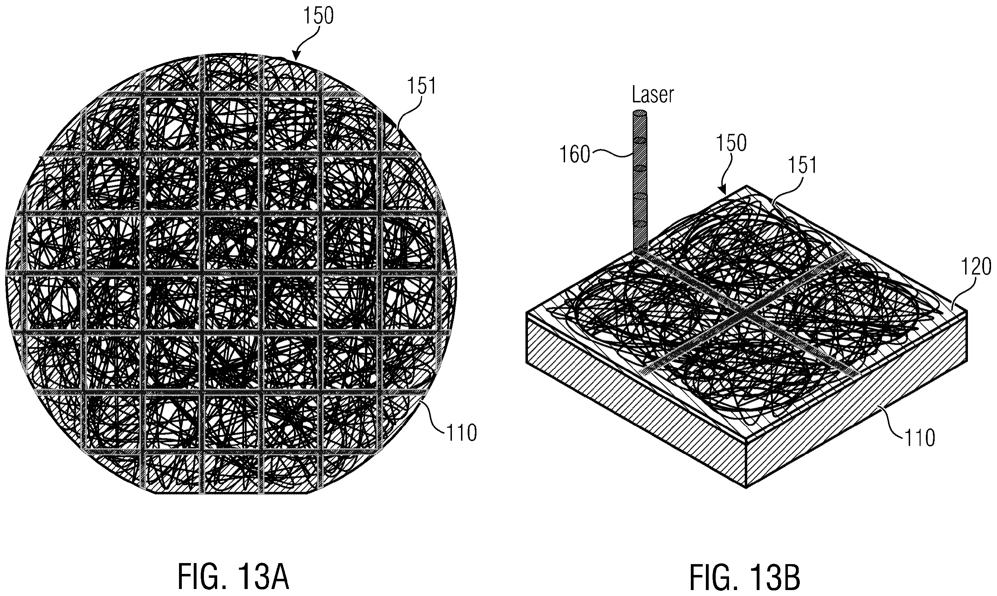

Accordingly, Figures 13A and 13B show alternative method steps, which are substantially the same or similar as the method steps previously described with reference to Figures 6A and 6B with the difference that the optional rigid protective mesh is not provided.

In particular, Figures 13A and 13B show a first thermal ablation step, e.g., a first laser-processing step, including guiding a laser beam 160 over that one side 111 of the wafer substrate 110 at which the polymer nanofibers 151 are applied in order to locally remove the polymer nanofibers 151 from the wafer substrate 110 and to uncover the underlying surface. The term locally in this regard means that the polymer nanofibers 151 are removed in the area being disposed to the laser beam 160.

In this non-limiting example, the laser beam 160 may be guided over the front side 111 of the wafer substrate 110. In case an additional passivation layer 120 is present, the laser beam 160 may be guided over said passivation layer 120. Accordingly, after the local removal of the polymer nanofibers 151 either the underlying surface of the passivation layer 120 is locally uncovered or the underlying surface of the bare substrate wafer 110 is locally uncovered.

The first laser-processing step may include applying a so-called laser grooving process for locally removing the polymer nanofibers 151.

The laser being used in the first laser-processing step may be configured / adjusted to locally remove the polymer nanofibers 151 only, i.e., without affecting / grooving the underlying surface. This can be achieved, for instance, by focusing the laser beam 160 onto the polymer nanofibers 151.

Alternatively, the laser being used in the first laser-processing step may be configured / adjusted to locally remove the polymer nanofibers 151 and groove the uncovered underlying surface. The latter example may be advantageous since a dicing line may already be pre-patterned into the locally uncovered underlying surface.

A suitable laser that may be used in the first laser-processing step can be a short-pulsed Nd:YAG laser having a wavelength between 300 nm and 400 nm.

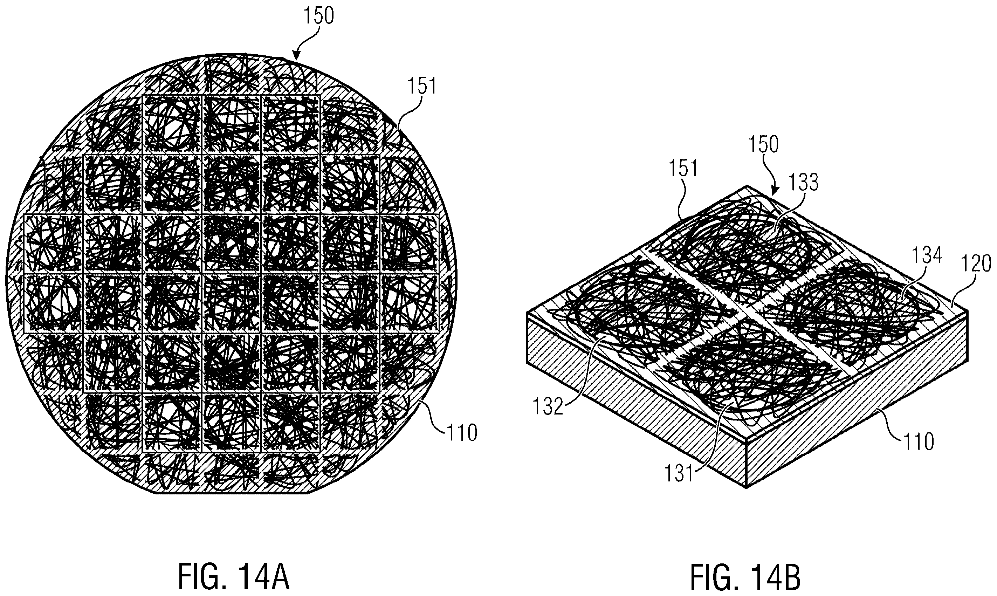

Figures 14A and 14B show further method steps, which are substantially the same or similar as the method steps previously described with reference to Figures 7A and 7B with the difference that the optional rigid protective mesh is not provided.

Figures 14A and 14B show the result after performing the above described first laser-processing step, i.e., Figures 14A and 14B show the condition of the separated polymer nanofibers 151 after the previously performed laser ablation (first laser-processing step). As can be seen, the polymer nanofibers 151 are locally removed in those areas that had been previously subjected to the laser beam 160. Accordingly, the underlying surface, e.g., the optional passivation layer 120, is locally uncovered in these areas.

As can further be seen in Figures 13A to 14B, the first laser-processing step may include a step of square-patterning the connected web formed by the polymer nanofibers 151 by guiding the laser beam 160 along straight lines between the previously described adjacent through holes 131, ..., 134, the straight lines being offset by 90° to each other resulting in a square pattern. Said square pattern may correspond to a desired die mapping, i.e., the polymer nanofibers 151 may be locally removed along lines, along which the final dies, i.e., the MEMS chips 100, will later be singulated.

The innovative concept further comprises a subsequent second thermal ablation step, e.g., a subsequent second laser-processing step, in which a standard chip singulation concept, such as stealth dicing, can be applied for singulating the MEMS chips 100. For example, a stealth dicing laser beam may be guided over the underlying surfaces that had previously been locally uncovered in the first laser-processing step.

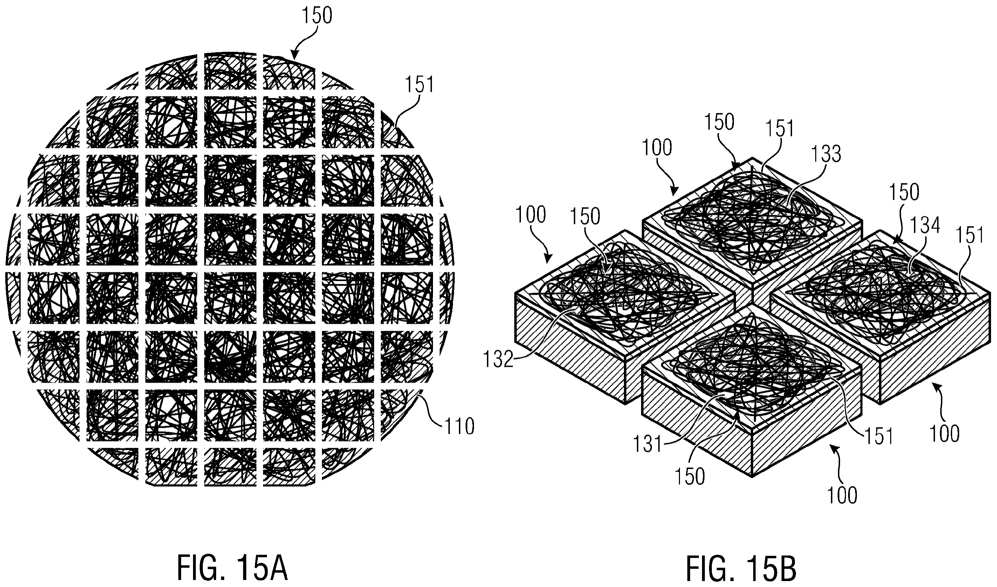

Figures 15A and 15B show further method steps, which are substantially the same or similar as the method steps previously described with reference to Figures 8A and 8B with the difference that the optional rigid protective mesh is not provided.

Figures 15A and 15B show the result after applying the innovative two-step laser process. As can be seen, a plurality of MEMS chips 100, each comprising an environmental barrier structure 150 made from polymer nanofibers 151, are singulated from the wafer substrate 110.

A standard stealth dicing process may be applied, in which the focus of the laser beam is set into the inside of the wafer substrate 110 for creating micro cracks therein. For example, the stealth dicing laser being used in the second laser-processing step may be a pulsed Nd:YAG laser having a wavelength between 1000 nm and 1100 nm. Accordingly, two different lasers may be used for the first and second laser-processing steps.

Even though the stealth dicing laser for the second laser-processing step may be more powerful, ongoing research of the applicant has shown that the laser beam of the stealth dicing laser may not be able to completely separate the polymer nanofibers 151 since its focus (where the most power sits) is set into the inside of the wafer substrate 110. Therefore, the stealth dicing laser beam may have less power at the site of the polymer nanofibers 151, which may result in an incomplete separation of the nanofibers 151. Accordingly, unseparated nanofiber-residues may remain at the wafer substrate 110 rendering it difficult to singulate the MEMS chips 100.

However, according to the herein described innovative concept, the polymer nanofibers 151 have been locally removed during the first laser-processing step, i.e., prior to applying the stealth dicing process. Thus, the stealth dicing laser does not need to additionally separate the polymer nanofibers 151, which would otherwise reside on the wafer surface if not removed before.

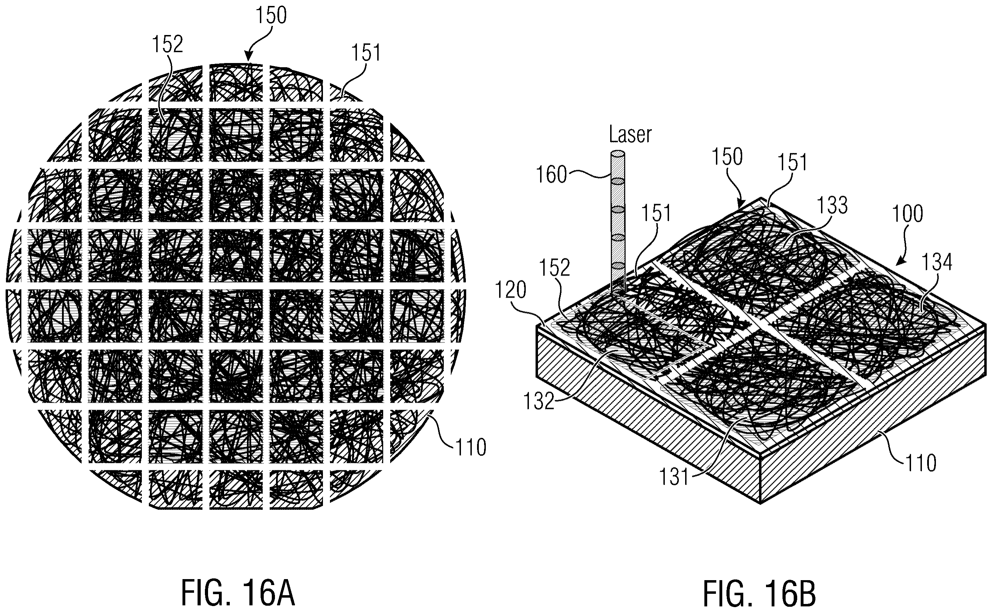

Figures 16A and 16B show further method steps, which are substantially the same or similar as the method steps previously described with reference to Figures 9A and 9B with the difference that the optional rigid protective mesh is not provided.

Regarding the singulated MEMS chips 100 as exemplarily depicted in Figure 15B, the applicant discovered that the environmental barrier structure 150 made from polymer nanofibers 151 may peel off from the underlying surface in some instances. For example, if a static pressure is applied from the back side 112, which may actually happen in microphone MEMS chips or pressure MEMS chips, the environmental barrier structure 150 may begin to detach from its underlying surface due to poor adhesion force.

During the herein disclosed innovative method the applicant found out that, by applying the thermal ablation process, the nanofibers 151 can be melted, wherein the molten nanofibers 151 create a bonding interface 152 to its underlying surface. Thus, adhesion between the environmental barrier structure 150 and its underlying surface can be drastically enhanced.

Figures 16A and 16B show an embodiment for melting the nanofibers 151. This process step is optional and can be applied, for example, after the above described first laser-processing step. As can be seen, this optional method step may contain a step of applying a thermal laser treatment including guiding a laser beam 160 over the polymer nanofibers 151 for melting them. The same laser like in the first laser-processing step may be used. Also, the laser parameters may be the same. However, it is also possible to use a different laser and/or different laser parameters.

Figure 16B shows polymer nanofibers 151 that have not yet been subjected to the thermal laser treatment and which, therefore, have not yet been melted. However, Figure 16B also shows polymer nanofibers 151 that have already been subjected to the thermal laser treatment and which, therefore, have already been melted. After curing of the molten polymer nanofibers 151, a joint interface 152 enhancing an adhesive force is created between the molten polymer nanofibers 151 and the underlying material.

Said underlying material can be at least one of the bare wafer substrate 110 and the optional passivation layer 120. Accordingly, the underlying material may comprise or consist of, for instance, silicon, polysilicon, TEOS or the like. It was observed that the adhesion force between the environmental barrier structure 150 and its underlying surface was enhanced for all structural parts 110, 120 of the innovative MEMS chip 100 by melting the nanofibers 151, as described above. In other words, the adhesion force could be enhanced for each of the bare wafer substrate 110 and the optional passivation layer 120.

In the non-limiting example shown in Figures 16A and 16B, the laser beam 160 was guided over the entire chip surface, i.e., over the through holes 131, ..., 134 and over the material surface surrounding the through holes 131, ..., 134. Accordingly, all (e.g., more than 90%) of the applied polymer nanofibers 151 may have been melted.

Thus, according to such an embodiment, the laser beam 160 may be guided over the wafer substrate 110 and over the through holes 131, ..., 134, such that polymer nanofibers 151 residing on the wafer substrate 110 as well as polymer nanofibers 151 residing over the through holes 131, ..., 134 are melted.

Even though not explicitly shown here, it may also be possible that the polymer nanofibers 151 may only be locally melted. For example, only polymer nanofibers 151 residing adjacent to the through holes 131, ..., 134 may be melted. In turn, the polymer nanofibers 151 residing directly over the through holes 131, ..., 134 may remain unmelted. This example may be preferable over a complete melting of polymer nanofibers 151 since the molten nanofibers 151 may become stiffer compared to their unmolten state. Accordingly, if polymer nanofibers 151 residing over the through holes 131, ..., 134 remain unmolten, they may remain a flexible / compliant behavior.

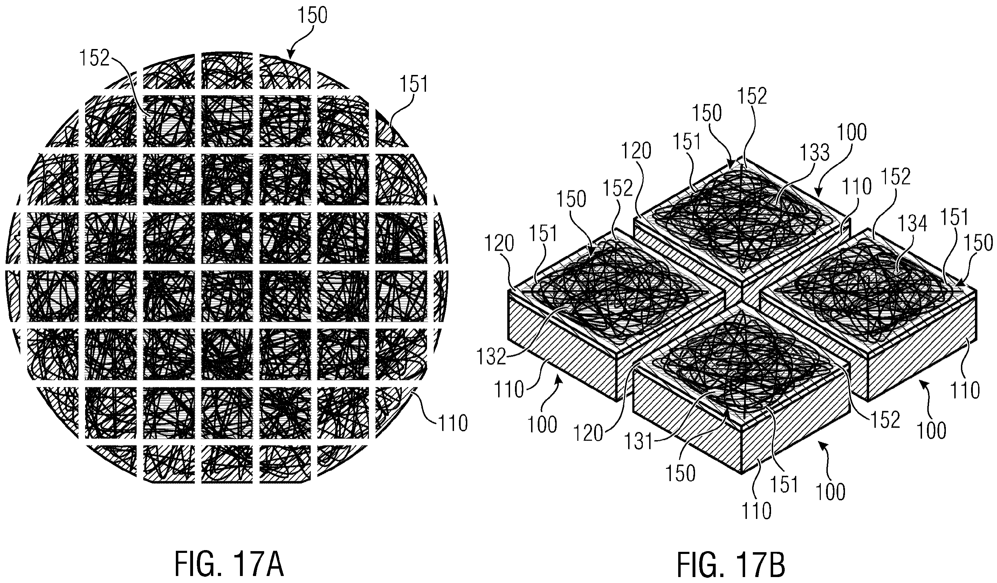

Figures 17A and 17B show further method steps, which are substantially the same or similar as the method steps previously described with reference to Figures 10A and 10B with the difference that the optional rigid protective mesh is not provided.

Figures 17A and 17B show the result after applying the above described second laser-processing step. A plurality of single MEMS chips 100 are created in the same or similar way as previously discussed with reference to Figures 15A and 15B, with the difference that the environmental barrier structure 150 comprises molten nanofibers 151 which create the above described bonding interface 152.

The herein disclosed innovative concept is very versatile since it can be applied for any kind of MEMS chips 100 containing nanofibrous mats (nanofibers). The innovative concept is advantageous since it comprises a physical processing method by using a laser, wherein the entire process is applicable at the end of the chip fabrication cycle. Furthermore, a highly selective patterning can be applied.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

While this disclosure has been described with reference to illustrative embodiments, this description is not intended to be construed in a limiting sense. Various modifications and combinations of the illustrative embodiments, as well as other embodiments of this disclosure, will be apparent to persons skilled in the art upon reference to the description. It is therefore intended that the appended claims encompass any such modifications or embodiments.

## Claims

1. A method for producing a MEMS chip (100) with an environmental barrier structure (150) made from polymer nanofibers (151), the method comprising:
providing a wafer substrate (110) having a front side (111) and an opposite back side (112),
forming a plurality of adjacent through holes (131, ..., 134) in said wafer substrate (110),
creating the environmental barrier structure (150) by applying polymer nanofibers (151) onto one of the front and back sides (111, 112) of the wafer substrate (110), such that the polymer nanofibers (151) are densely connected to form a connected web that covers the wafer substrate (110) including the through holes (131, ..., 134) formed therein,
singulating a plurality of MEMS chips (100) from the wafer substrate (110) by applying a two-step laser process comprising:
a first laser-processing step including guiding a laser beam (160) over the one side of the wafer substrate (110) at which the polymer nanofibers (151) are applied in order to locally remove the polymer nanofibers (151) from the wafer substrate (110) and to locally uncover an underlying surface, and
a subsequent second laser-processing step including applying a stealth dicing process for singulating the MEMS chips (100) by guiding a stealth dicing laser beam over the locally uncovered surfaces.

2. The method according to claim 1,
wherein the laser being used in the first laser-processing step is different from the laser being used in the subsequent second laser-processing step.

3. The method according to claim 2,
wherein the laser beam (160) of the laser being used in the first laser-processing step is focused on the polymer nanofibers (151), and
wherein the stealth dicing laser beam being used in the subsequent second laser-processing step is focused on the inside of the wafer substrate (110).

4. The method according to claim 2 or 3,
wherein the first laser-processing step includes applying a laser grooving process for removing the polymer nanofibers (151).

5. The method according to any one of the preceding claims,
wherein the laser being used in the first laser-processing step is adjusted to remove the polymer nanofibers (151) only without grooving the uncovered underlying surface.

6. The method according to any one of claims 1 to 4,
wherein the laser being used in the first laser-processing step is adjusted to remove the polymer nanofibers (151) and to groove the uncovered underlying surface.

7. The method according to any one of claims 2 to 6,
wherein the laser being used in the first laser-processing step is a short-pulsed Nd:YAG laser having a wavelength between 300 nm and 400 nm, and
wherein the stealth dicing laser being used in the second laser-processing step is a pulsed Nd:YAG laser having a wavelength between 1000 nm and 1100 nm.

8. The method according to any one of the preceding claims,
wherein the first laser-processing step includes
square-patterning the connected web formed by the polymer nanofibers (151) by guiding the laser beam (160) along straight lines between the adjacent through holes (131, ..., 134), the straight lines being offset by 90° to each other resulting in a square pattern.

9. The method according to any one of the preceding claims,
wherein a silicon oxide layer (120) is arranged between the bare wafer material and the polymer nanofibers (151), and
wherein the underlying surface being uncovered during the first laser-processing step corresponds to the silicon oxide layer (120).

10. The method according to any one of the preceding claims,
wherein prior to the step of applying the polymer nanofibers (151) onto the one of the front and back sides (111, 112) of the wafer substrate (110), the method comprises a further step of
providing a rigid mesh (141, ..., 144) covering at least one of the through holes (131, ..., 134), wherein the rigid mesh (141, ..., 144) is flush with the one of the front and back sides (111, 112) of the wafer substrate (110) at which the polymer nanofibers (151) are to be applied, and
applying the polymer nanofibers (151) onto the one of the front and back sides (111, 112) of the wafer substrate (110) and onto the rigid meshes (141, ..., 144).

11. The method according to any one of claims 1 to 9,
wherein the step of applying the polymer nanofibers (151) onto the one of the front and back sides (111, 112) of the wafer substrate (110) includes
applying the polymer nanofibers (151) over the non-obstructed open through holes (131, ..., 134).

12. The method according to any one of the preceding claims,
comprising a further method step of melting the polymer nanofibers (151) by applying a thermal laser treatment including guiding a laser beam (160) over the polymer nanofibers (151) for melting them,
wherein, after curing of the molten polymer nanofibers (151), a bonding interface (152) is created for enhancing an adhesive force between the molten polymer nanofibers (151) and the underlying material.

13. The method according to claim 12,
wherein the step of melting the polymer nanofibers (151) by applying the thermal laser treatment includes
using the same laser (160) as in the first laser-process step or using a laser being different from the lasers being used in the first and second laser-processing steps.

14. The method according to claim 12 or 13,
wherein the step of melting the polymer nanofibers (151) by applying the thermal laser treatment includes
guiding the laser beam (160) over the wafer substrate (110) while omitting the through holes (131, ..., 132) formed therein, such that only polymer nanofibers (151) residing on the wafer substrate (110) are melted while other polymer nanofibers (151) residing over the through holes (131, ..., 134) remain substantially unmelted.

15. The method according to claim 12 or 13,
wherein the step of melting the polymer nanofibers (151) by applying the thermal laser treatment includes
guiding the laser beam (160) over the wafer substrate (110) and over the through holes (131, ..., 134), such that polymer nanofibers (151) residing on the wafer substrate (110) as well as other polymer nanofibers (151) residing over the through holes (131, ..., 134) are melted.
